# EUROPEAN PATENT APPLICATION

(11) **EP 2 467 005 A1**
(43) Date of publication of application: **20.06.2012**
(21) Application number: 10195866.8
(22) Date of filing: 20.12.2010
(51) Int. Cl.: H05K 7/20

(54) **Cooling component of an electronic unit**

(71) Applicant: Vetco Gray Controls Limited, Bristol BS48 1BS (GB)
(72) Inventor: Stokes, Martin, Newport, Gwent NP20 4LT (GB)
(74) Representative: Newstead, Michael John

(57) **Abstract**

There is disclosed a method of enabling the cooling of components (5) of an electronic unit, comprising providing a thermally conductive liquid or gel in contact with the components. In an example, the unit is an electronic module comprising a casing (1) which comprises metallic material and housing the components, the method comprising including such liquid or gel in the casing to the entire space within the casing apart from the components so that heat from the components can be conducted via the liquid or gel to the casing.

## Description

### Field of the Invention

The present invention relates to the cooling of components of an electronic unit.

### Background of the Invention

In offshore oil and gas production control systems, much of the equipment is installed on the seabed. Such subsea equipment has to be highly reliable and operate in the harsh environment subsurface and is required to operate satisfactorily over a life of up to 25 years. As exploration and production moves into deeper waters, the subsurface sea environment gets harsher and the costs and risks associated with intervention and repair or replacement of faulty equipment increases considerably. For future systems, operators are requiring increased reliability and increased equipment lifetimes from the current 25 years to possibly 50 years. Existing designs will find it difficult to meet such a long extended lifetime and designers will need to find alternative or new methods of extending equipment lifetimes. In particular, there will be a need to find methods of increasing the lifetime of electronic equipment used subsurface.

As prior art in the field of the cooling of components in an electronic unit, there may be mentioned: US-A-3 212 564; US-A-3 784 885; US-A-4 149 219; US-A-4 400 858; US-A-4 679 250; US-A-4 689 720; US-A-4 855 870; US-A-4 858 068; US-A-4 962 445; US-A-5 105 337; US-A-5 247 425; US-A-5 666 457; US-A-5 679 457; US-A-7 733 651; US 2005/0180113 A1; US 2002/154487 A1; DE-A- 199 25 983; DE-A-102 46 577; DE-A-40 04 457; GB-A-2 153 151; WO 01/13692; WO 2007/041738; and EP-A-2 048 928.

### Summary of the Invention

According to the present invention from one aspect, there is provided a method of enabling the cooling of components of an electronic unit, comprising providing a thermally conductive liquid or gel in contact with the components, wherein the unit is an electronic module which comprises a casing comprising metallic material and housing the components, the method comprising including such liquid or gel in the casing to fill the entire space within the casing apart from the components so that heat from the components can be conducted via the liquid or gel to the casing.

According to the present invention from another aspect, there is provided an electronic unit with a thermally conductive liquid or gel in contact with components of the unit for use in cooling the components, wherein the unit is an electronic module which comprises a casing comprising metallic material and housing said components, said liquid or gel filling the entire space within the casing apart from the components so that heat from the components can be conducted via the liquid or gel to the casing.

Said unit could be for use subsea. In this case, said electronic unit could comprise a subsea electronics module used or for use in a subsea control module of a hydrocarbon well installation.

Said components could comprise electronic devices on circuit boards, which could be carried by metallic support means in thermal contact with said casing (such as metallic card frames which carry the circuit boards).

The present invention also comprises a subsea control module for a hydrocarbon well installation, including a subsea electronics module according to the invention.

There is ample evidence to show that the lifetime of electronic equipment is dependent on the operating temperature of the components, even when they are operating within the operational temperature limits quoted by the manufacturer. It is generally accepted by designers, that for every 10 degree C rise in temperature, the lifetime is reduced by approximately 50% and similarly, reducing the operating temperature increases the lifetime of equipment. An embodiment of this invention involves the inclusion of an electrically nonconductive, thermally conductive, gel to fill the spaces within a subsea electronic unit. Such units are normally sealed units and hitherto have been pressurised with air or nitrogen gas. The gel will have a high heat transfer coefficient so that heat is transferred more efficiently from electronic devices to the casing of the electronic unit compared to the air or pressurised nitrogen gas which would normally fill the spaces. This will have the effect of lowering the operating temperature of the electronic devices, resulting in an increase in their lifetime and therefore in the reliability of the equipment. As such this invention is particularly but not exclusively applicable for use in a subsea electronics module (SEM).

### Brief Description of the Drawings

Fig. 1 is a longitudinal section through an SEM according to the invention;
Fig. 2 is a transverse section through the SEM.

### Description of an Embodiment of the Invention.

Subsurface equipment of a subsea hydrocarbon well installation is usually mounted on a Christmas tree installed on the seabed and the control and monitoring of all the well control processes, such as opening and closing of valves, is enabled using a subsea control module (SCM) which is also usually mounted on the Christmas tree. The SCM is a self-contained sealed unit having a steel casing and the space inside that is not taken up by equipment is filled with insulating oil, the purpose of which is to pressurise the system against the outside sea water pressure and provide a suitable environment for the internal equipment which is mounted on a metal baseplate.

An SCM houses a subsea electronics module (SEM), the main purposes of which are to:
receive power and control orders from topside;
provide drives for controlling the valve actuators which control the valves mounted on the tree and at the well; and
receive analogue data from the sensor instrumentation mounted on the tree and at the well and transmit this data topside.

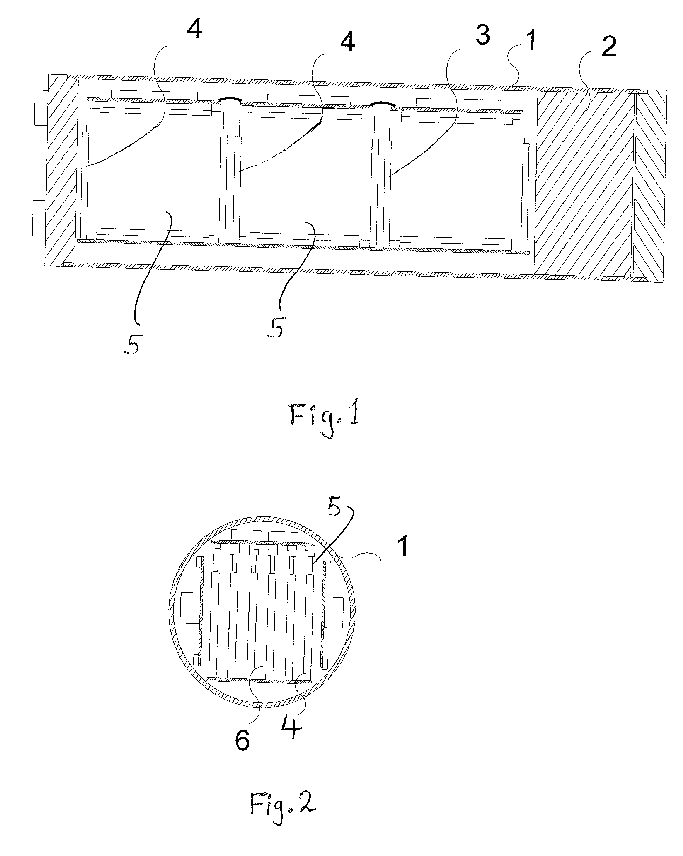

The SEM shown in Fig. 1 is a sealed self-contained unit with a cylindrical metallic casing 1. Hitherto, the casing 1 is, typically, dry air or nitrogen filled at a pressure of one atmosphere to provide a benign environment for the internal electrical and electronic devices. It essentially consists of three sections:
a front end assembly 2 which houses a transformer module;
a power supply card frame 3 into which are fitted power supply and diplexer circuit boards; and
data acquisition and control card frames 4 into which are fitted printed circuit boards 5 associated with data acquisition and valve actuator controls.

The various components in the SEM include electronic devices which are high density integrated circuits and are all industrial standard components and the module is designed to operate over a temperature range of -18 degrees C to + 70 degrees C. The main method of cooling the electronic devices on the circuit boards is via the card frames, which are of metal, and copper side bars which are fitted to the unit through to the outside casing and to the base plate of the SCM, on which the SEM is mounted and which is at the temperature of the outside sea water.

By filling the spaces 6 within the SEM, such as those between the circuit boards, and all the other spaces with a non-electrically conductive, thermally conductive gel which has a high heat transfer coefficient, the transfer of heat to the metallic casing 1 of the SEM is significantly increased compared to when air or nitrogen (which are poor conductors of heat) is used to fill the air spaces. Thus, apart from the components themselves, the entire space within casing 1 is filled with the gel. The addition of a thermally conductive gel inside the SEM provides two routes for the transfer of heat from, for example, the circuit board mounted electronic devices to the SEM casing - that is through the metal card frames and copper side bars and through the thermally conductive gel.

Extensive testing of existing SEMs indicates that the operating temperature of the electronics is approximately 30 degrees C when fitted in an SCM submersed in sea water at 4 degrees C, the expected sea temperature. This is a differential temperature of 26 degrees C. Thermal calculations based on this data on SEM have shown that, when heat is conducted via the metal card frames and side bars and through a suitable gel, the operating temperature of the electronic devices can be reduced by approximately 10 degrees C, thus potentially doubling their lifetime.

Various forms of gel are suitable. One particular suitable gel is made by The Bergquist Company, of Bramenberg 9a, 3755 BT Eemmes, Netherlands under the name "Gap Filler 1100SF (Two-Part)" which is a thermally conductive, silicone-free liquid gap filling material. Basically, the material starts off as a gel and cures to a soft, flexible elastomer with a natural tackiness. It is easy to apply but once cured it is somewhat like a rubbery substance, i.e. it does not stress the components but does not flow like a liquid, making handling and assembly easier. Its intended use as a thermally conductive material is typically to take away the imperfections between an electronic device and its heatsink (which at the microscopic level have rough edges with pockets of air being formed). This type of material fills in the air gaps providing a much better heat transfer. In contrast to that, gel used according to the invention fills the entire space within the casing of an electronic unit.

As an alternative to a gel, a suitable non-electrically conductive, thermally conductive, liquid can be used, such as a non-electrically conductive oil.

### Advantages of using the Invention

The use of this invention can result in the following technical advantages:
a reduction in the operating temperature of electronic devices; and
an increased life expectancy and reliability of subsea electronics

Commercial advantages resulting from this invention are:
maintenance schedules can be reduced and lifecycle costs reduced; and
longer field life projects become feasible.

## Claims

1. A method of enabling the cooling of components of an electronic unit, comprising providing a thermally conductive liquid or gel in contact with the components wherein the unit is an electronic module which comprises a casing comprising metallic material and housing the components, the method comprising including such liquid or gel in the casing to fill the entire space within the casing apart from the components so that heat from the components can be conducted via the liquid or gel to the casing.

2. A method according to claim 1, wherein the unit is used subsea.

3. A method according to claim 1 or 2, wherein said electronic unit comprises a subsea electronics module used in a subsea control module of a hydrocarbon well installation.

4. A method according to any preceding claim, wherein said components comprise electronic devices on circuit boards.

5. A method according to claim 4, wherein said circuit boards are carried by metallic support means in thermal contact with said casing.

6. An electronic unit with a thermally conductive liquid or gel in contact with components of the unit for use in cooling the components, wherein the unit is an electronic module which comprises a casing comprising metallic material and housing said components, said liquid or gel filling the entire space within the casing apart from the components so that heat from the components can be conducted via the liquid or gel to the casing.

7. A unit according to claim 6 for use subsea.

8. A unit according to claim 7, wherein said electronic unit comprises a subsea electronics module for use in a subsea control module of a hydrocarbon well installation.

9. A unit according to any of claims 6 to 8, wherein said components comprise electronic devices on circuit boards.

10. A unit according to claim 9, wherein said circuit boards are carried by metallic support means in thermal contact with said casing.

11. A subsea control module for a hydrocarbon well installation including a subsea electronics module according to claim 8 or either of claims 9 and 10 as dependent on claim 8.
